# EUROPÄISCHE PATENTSCHRIFT

(11) **EP 2 637 485 B1**
(45) Veröffentlichungstag und Bekanntmachung des Hinweises auf die Patenterteilung: **12.11.2014**
(21) Anmeldenummer: 13152005.8
(22) Anmeldetag: 21.01.2013
(51) Int. Cl.: H05K 1/02, G06K 7/00

(54) **Kartenleser mit einem eine Leiterbahnstruktur aufweisenden Kunststoffspritzteil, Folienverbund, Verfahren zum Ausbilden einer Leiterbahnstruktur**
Card reader with a conductor path structure with a plastic injection moulded component, composite film, method of forming a conductor path structure
Lecteur de carte avec une pièce d'injection en plastique comprenant une structure à pistes conductrices, feuille composite, procédé de fabrication d'une structure à pistes conductrices

(30) Priorität: 06.03.2012 DE 102012203474
(43) Veröffentlichungstag der Anmeldung: 11.09.2013
(73) Patentinhaber: ddm hopt + schuler GmbH & Co. KG., 78628 Rottweil (DE)
(72) Erfinder: Hopt, Karl-Rudolf, 78628 Rottweil (DE)
(74) Vertreter: Kohler Schmid Möbus

(56) Entgegenhaltungen:
- EP-A1- 1 785 911
- EP-A2- 0 892 591
- US-A- 4 772 496
- US-A1- 2007 257 398
- US-A1- 2008 164 320

## Beschreibung

Die vorliegende Erfindung betrifft ein Kunststoffspritzteil mit einer daran vorgesehenen Leiterbahnstruktur, insbesondere Bohrschutz-Leiterbahnstruktur, ein Verfahren zum Herstellen eines solchen Kunststoffspritzteils sowie auch einen Kartenleser mit einem solchen Kunststoffspritzteil. Der Stand der Technik wird unter anderem in den Dokumenten US 4 772 496 A, US 2007/257398 A1, EP 0 892 591 A2, EP 1 785 911 A1, US 2008/164320 A1 beschrieben.

Ein Kunststoffspritzteil mit einer daran vorgesehenen Bohrschutz-Leiterbahnstruktur ist beispielsweise aus der DE 10 2009 026 466 B3 in Form einer Bohrschutzhaube für einen Kartenleser bekannt geworden.

Diese Bohrschutzhaube ist ein spritzgegossenes Kunststoffteil, dessen Innenseite eine metallisierte Mäander-Leiterbahnstruktur als Bohrschutz aufweist. Dazu wurde auf die Innenseite vollflächig bzw. flächendeckend mit einem Laser eine Mäanderbahnstruktur (ca. 0,15 mm Bahnbreite) im Abstand von ca. 0,25 mm abgetragen. Nach dieser Laserstrukturierung wurde das Kunststoffteil metallisiert (10±4 µm chem. CU; 6±2 µm chem. Ni; >0,06µm Au). Durch die nun metallisierte Bohrschutz-Leiterbahnstruktur ist auf der gesamten Innenseite zwischen zwei Anschlusskontakten eine durchgehende elektrische Leiterbahn gelegt. Wenn die Bohrschutzhaube zu Manipulationszwecken durchbohrt oder abgeschliffen wird, wird dabei auch die durchgehende Leiterbahn durchtrennt, über die im Betrieb ein Strom fließt. Dies wird von einer Überwachungseinheit erkannt, die dann keinen Lesevorgang mehr zulässt bzw. den Kartenleser außer Funktion setzt.

Dieses bekannte Verfahren zum Herstellen einer Bohrschutz-Leiterbahnstruktur an einem Kunststoffspritzteil ist aufgrund der Laserstrukturierung und der anschließenden Metallisierung mit hohem Kosten- und Zeitaufwand verbunden.

Es ist demgegenüber die Aufgabe der vorliegenden Erfindung, ein Kunststoffspritzteil mit einer daran vorgesehenen Leiterbahnstruktur anzugeben, das einfacher und mit geringerem Kosten- und Zeitaufwand hergestellt werden kann, sowie ein zugehöriges Herstellungsverfahren anzugeben.

Diese Aufgabe wird erfindungsgemäß durch ein Kunststoffspritzteil gemäß Anspruch 1 sowie durch ein Herstellungsverfahren gemäß Anspruch 11 gelöst.

Erfindungsgemäß wird die mit einer mäanderförmigen Leiterbahnstruktur durchzogene flexible Kunststofffolienleiterplatte ("Flexleitung") in das Spritzwerkzeug eingelegt, und dann wird die zuvor auf die Kunststofffolienleiterplatte stoffschlüssig aufgebrachte Kunststofffolie ihrerseits durch den Hinterspritzvorgang mit dem Kunststoffspritzteil stoffschlüssig verbunden bzw. verschmolzen. Die Verbindung der Kunststofffolienleiterplatte mit dem Kunststoffspritzteil kann nur durch ein Zerstören der Kunststofffolienleiterplatte getrennt werden. Im Falle einer handelsüblichen Polyimidfolienleiterplatte beträgt der Schmelzpunkt der Polyimid-Trägerfolie ca. 280°C, während das beim Spritzgießen üblicherweise verwendet Kunststoffgranulat einen Schmelzpunkt von weniger als 200°C. Dadurch kommt es beim Kunststoffhinterspritzen einer handelsüblichen Polyimidfolienleiterplatte zu keiner Verbindung zwischen dem Spritzgießteil und der Polyimidfolienleiterplatte, insbesondere zu keiner stoffschlüssigen Verbindung.

Die erfindungsgemäße Kunststofffolie muss sich sowohl auf die Polyimid-Trägerfolie aufkleben bzw. auflaminieren lassen als auch bei den beim Kunststoffhinterspritzen auftretenden Temperaturen von weniger als 200°C durch die Kunststoffschmelze angeschmolzen werden, um eine dauerhafte stoffschlüssige Verbindung mit dem Kunststoffteil einzugehen.

Im Falle einer handelsüblichen Polyimidfolienleiterplatte mit einer Polyimid-Trägerfolie (50µm Kapton) haben sich bei der Herstellung eines Spritzgießteils aus dem Kunststoffmaterial "PC Lexan 920 (VO) Master Batch weiß 0,5%" die von der Firma Schreiner Group GmbH & Co. KG, D-85764 Oberschleißheim, unter der Artikel-Nr. 81-91 vertriebene PET-Folie als geeignete Kunststofffolie und der Klebstoff "Typ SW83G, Stärke 0,188 mm" der Firma SKC CO LTD, Plant Management Team, 633 Chongja-Dong, Changan-Gu, Suwon-Shi, Kyonggi-do 440-840, Republic of Korea, als geeignet zum Aufkleben der PET-Folie auf die Polyimid-Trägerfolie erwiesen.

Aufgrund ihrer Biegeflexibilität kann die Kunststofffolienleiterplatte an jede beliebige, z.B. ebene, gekrümmte oder gestufte Oberflächenform des Kunststoffspritzteils angebracht werden.

Die Erfindung betrifft in einem weiteren Aspekt auch einen Kartenleser zum Datenaustausch mit einer Datenkarte, insbesondere mit einer Chipkarte, mit einem Kartenlesergehäuse, bei dem mindestens eine Gehäusewand, und zwar bevorzugt eine mit einem Karteneinführschlitz zum Einführen der Datenkarte in den Kartenleser versehene Frontwand des Kartenlesergehäuses, durch ein wie oben beschrieben ausgebildetes Kunststoffspritzteil gebildet ist. Die Kunststofffolienleiterplatte ist dabei vorteilhaft auf der Innenseite der Gehäusewand angeordnet. Wenn eine solche Gehäusewand zu Manipulationszwecken durchbohrt oder abgeschliffen wird, wird dabei zwangsläufig auch die stromdurchflossene Bohrschutz-Leiterbahnstruktur der Kunststofffolienleiterplatte beschädigt. Dies wird von einer Überwachungseinheit erkannt, die dann keinen Lesevorgang mehr zulässt bzw. den Kartenleser außer Funktion setzt.

Bevorzugt umfasst das Kartenlesergehäuse vier ineinander gesteckte Seitenwände, die als mit einer Bohrschutz-Leiterbahnstruktur versehene Leiterplatten ausgebildet sind, welche miteinander elektrisch kontaktverbunden, insbesondere miteinander verlötet sind, wobei die vier ineinander gesteckten Seitenwände eine innenseitig umlaufende Nut aufweisen, in welche die Frontwand allseitig eingesteckt ist. Besonders bevorzugt sind dabei die vier ineinander gesteckten Seitenwände und die Kunststofffolienleiterplatte der mit den Seitenwänden steckverbundenen Frontwand miteinander elektrisch kontaktverbunden, insbesondere miteinander verlötet. Weiterhin bevorzugt umfasst das Kartenlesergehäuse noch eine mit den vier Seitenwänden steckverbundene Rückwand, die ebenfalls als eine mit einer Bohrschutz-Leiterbahnstruktur versehene Leiterplatte ausgebildet ist, welche mit den Seitenwänden elektrisch kontaktverbunden, insbesondere miteinander verlötet ist. Wenn dann eine der Wände des in sich geschlossenen Kartenlesergehäuses zu Manipulationszwecken aus dem Steckverbund der anderen Wände herausgelöst wird, wird dabei zwangsläufig die dazwischen ausgebildete elektrische Kontaktverbindung unterbrochen. Auch dies wird von der Überwachungseinheit erkannt, die dann keinen Lesevorgang mehr zulässt bzw. den Kartenleser außer Funktion setzt.

In einem weiteren Aspekt betrifft die Erfindung auch den Folienverbund aus einer Kunststofffolienleiterplatte, insbesondere Polyimidfolienleiterplatte, und mindestens einer darauf aufgeklebten oder auflaminierten Kunststofffolie, die beim Spritzgießen eines Kunststoffteils mit diesem stoffschlüssig verbindbar ist.

Weitere Vorteile der Erfindung ergeben sich aus der Beschreibung, den Ansprüchen und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine Frontwand des erfindungsgemäßen Kartenlesers;
- Fig. 2: einen an der Frontwand im In-Mold-Spritzgießverfahren angebrachten Folienverbund;
- Fig. 3: den Schichtenaufbau des in Fig. 2 gezeigten Folienverbunds;
- Fig. 4: ein Detail gemäß IV in Fig. 1;
- Fign. 5a, 5b: den erfindungsgemäßen Kartenleser in einer perspektivischen Ansicht von oben (Fig. 5a) und in einer Draufsicht (Fig. 5b), wobei eine obere Gehäusewand des Kartenlesergehäuses ausgelassen ist;
- Fig. 6: eine untere Gehäusewand des Kartenlesergehäuses; und
- Fign. 7a, 7b: den erfindungsgemäßen Kartenleser in einer Längsschnittansicht (Fig. 7a) und in einer Querschnittansicht (Fig. 7b) gemäß VIIb-VIIb in Fig. 7a.

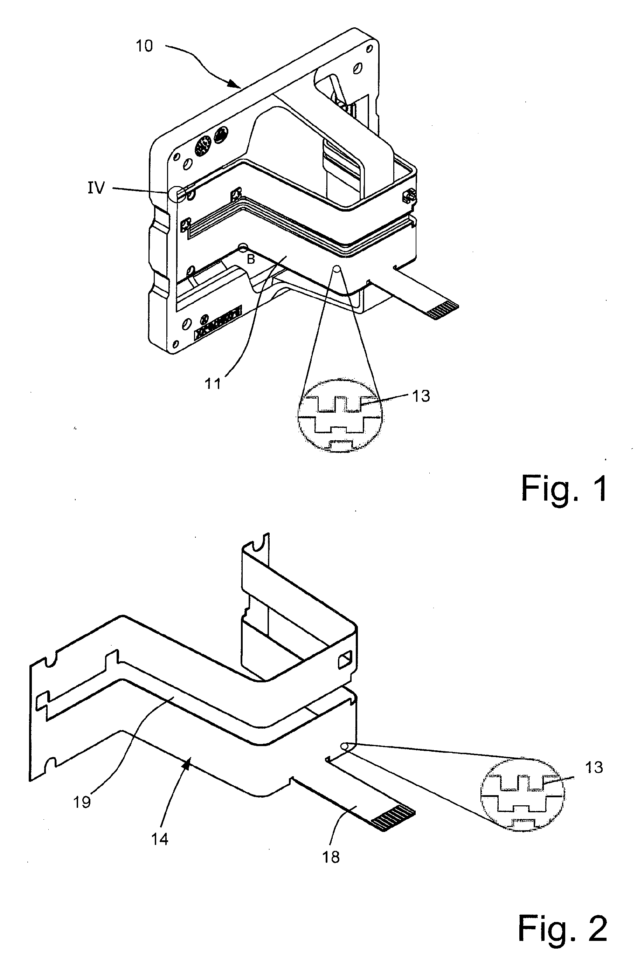

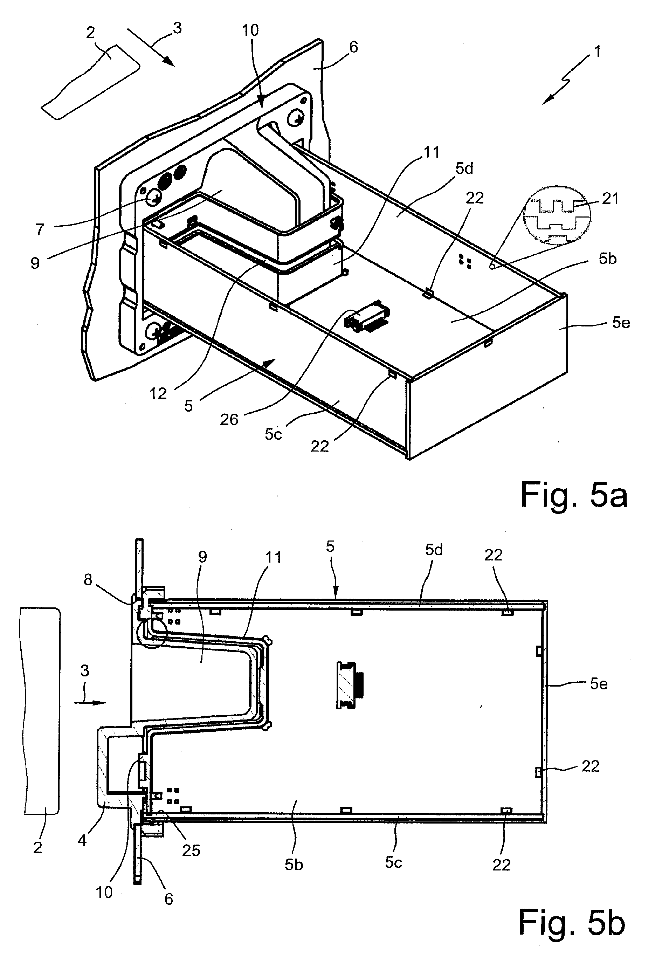

Das in **Fig. 1** gezeigte Kunststoffspritzteil ist die Frontwand **10** eines so genannten Push/Pull-Kartenlesers 1 (Fign. 5a, 5b), bei dem eine Chipkarte **2** durch den Benutzer in Einführrichtung **3** über ein Einführmundstück **4** in das Kartenfesergehäuse **5** bis in ihre Datenaustauschposition eingeführt und nach dem Datenaustausch vom Benutzer wieder aus dem Kartenlesergehäuse 5 herausgezogen wird. Die Chipkarte 2 trägt zum Speichern der Daten einen Mikrochip (nicht gezeigt), dessen Kontakte als elektrische Kontaktfelder (nicht gezeigt) auf der Kartenoberfläche vorgesehen sind. In der Datenaustauschposition werden diese Kontaktfelder von einer an sich bekannten Kontaktiereinheit (nicht gezeigt) für einen Datenaustausch kontaktiert.

Die Frontwand 10 und das Einführmundstück 4 werden zu beiden Seiten einer Automatenwand **6** angeordnet und durch Schraubverbindungen **7** gegeneinander verspannt, wodurch das Kartenlesergehäuse 5 und das Einführmundstück 4 an der Automatenwand 6 befestigt sind. Die Automatenwand 6 weist eine Öffnung **8** auf, in die das Einführmundstück 4 mit einer Griffmulde **9** hindurchgreift. Wie in Fig. 5a gezeigt, weist die Frontwand 10 im Bereich der Griffmulde 9 einen nach hinten in das Kartenlesergehäuse 5 hinein zurückversetzten Bügelabschnitt **11** auf, um der Kontur der Griffmulde 9 zu folgen. Der Bügelabschnitt 11 weist einen Karteneinführschlitz **12** auf, durch den die Chipkarte 2 hindurch in das Kartenlesergehäuse 5 eingeführt wird. Die Frontwand 10 weist an ihrem Bügelabschnitt 11 innenseitig eine mäanderförmige Bohrschutz-Leiterbahnstruktur **13** auf, die mittels eines in **Fig. 2** gezeigten flexiblen Folienverbunds **14** angebracht wurde.

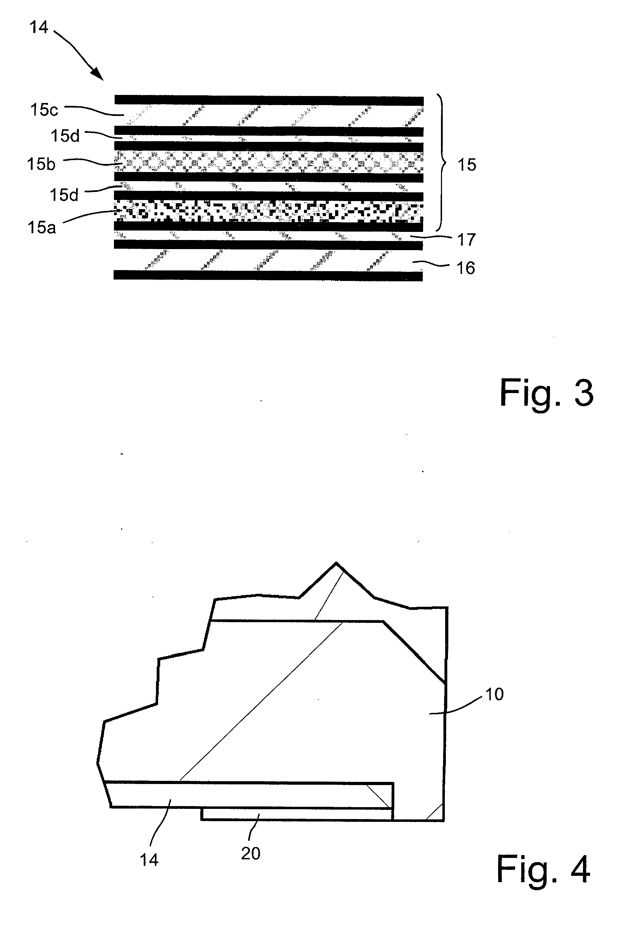

Wie in **Fig. 3** gezeigt, ist der Folienverbund 14 durch eine an sich bekannte flexible Polyimidfolienleiterplatte **15,** welche die Bohrschutz-Leiterbahnstruktur 13 aufweist, und eine darauf aufgeklebte Kunststofffolie **16** (PET-Folie Artikel-Nr. 81-91 der Firma Schreiner Group GmbH & Co. KG, D-85764 Oberschleißheim). Genauer gesagt weist die Polyimidfolienleiterplatte 15 eine Polyimid-Trägerfolie **15a** (50µm Kapton), eine Bohrschutz-Leiterbahnstrukturfolie **15b** aus Kupfer (35µRA) und eine Deckfolie **15c** auf, die miteinander jeweils über eine Klebstoffschicht **15d** verklebt sind. Die Kunststofffolie 16 ist auf die Polyimid-Trägerfolie 15a über eine Klebstoffschicht **17** (Klebstoff "Typ SW83G, Stärke 0,188 mm" der Firma SKC Klebstoff "Typ SW83G, Stärke 0,188 mm" der Firma SKC CO LTD, Plant Management Team, 633 Chongja-Dong, Changan-Gu, Suwon-Shi, Kyonggi-do 440-840, Republic of Korea, aufgeklebt. Dieser Folienverbund 14 wird, mit der Kunststofffolie 16 nach innen, in ein Spritzwerkzeug eingelegt und im In-Mold-Spritzgießverfahren mit der Frontwand 10 hinterspritzt, wodurch die Kunststofffolie 16 mit der Frontwand 10 stoffschlüssig verschmolzen wird und somit der Folienverbund 14 mit dem Kunststoffspritzteil unlösbar verbunden ist. Die Polyimidfolienleiterplatte 15 weist noch einen streifenförmigen Leiterbahn-Anschlussabschnitt **18** auf. Der Folienverbund 4 weist einen dem Karteneinführschlitz 12 entsprechenden Folienschlitz **19** auf.

Wie in **Fig. 4** gezeigt, kann der Folienverbund 14 auf seiner anderen Seite randseitig von einem Abschnitt **20** der Frontwand 10 übergriffen sein, wobei die Deckfolie 15c mit dem Abschnitt 20 keine stoffschlüssige Verbindung eingeht.. Die Folienränder der Polyimidfolienleiterplatte 15 sind dadurch vollständig von Kunststoff umschlossen und können nicht als Abziehhilfe zum Abziehen der Polyimidfolienleiterplatte 15 von der Frontwand 10 genutzt werden.

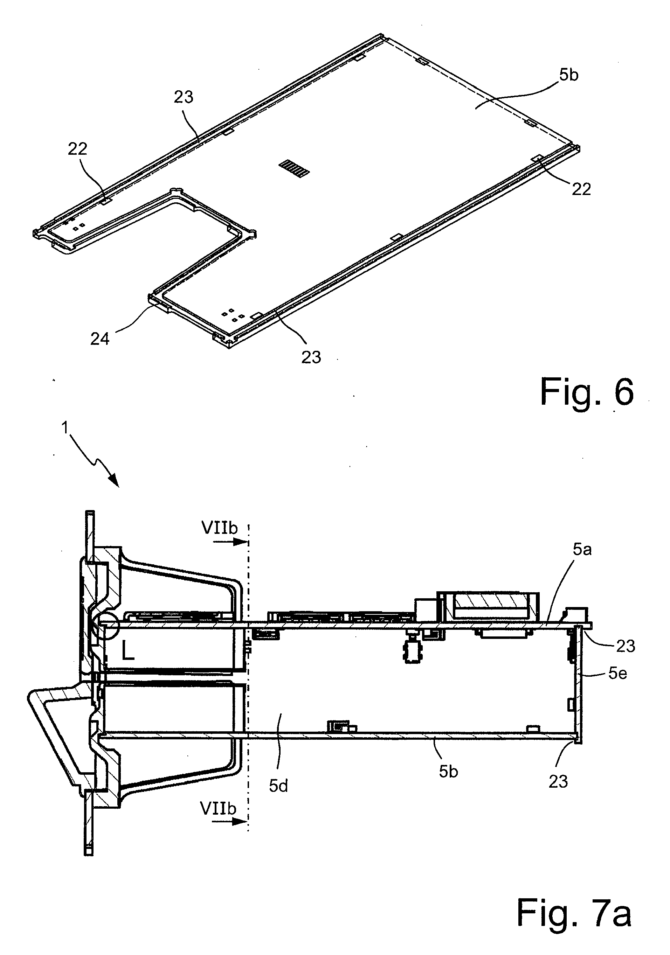

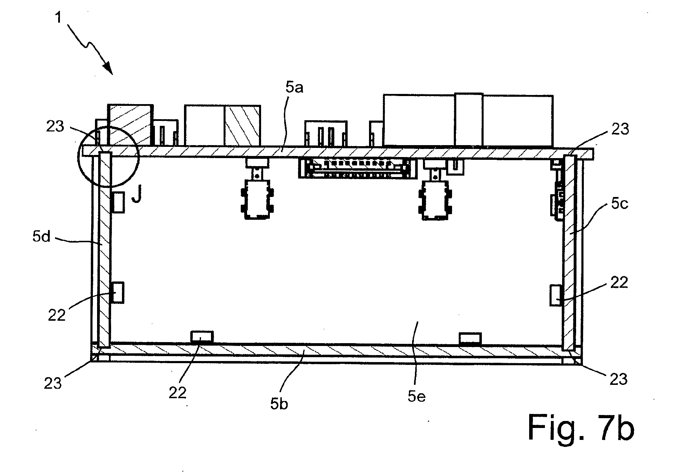

Neben der Frontwand 10 umfasst das Kartenlesergehäuse 5 weiterhin eine obere Gehäusewand **5a** (Fign. 7a, 7b), eine untere Gehäusewand **5b,** zwei Seitenwände **5c, 5d** sowie eine Rückwand **5e.** Das Kartenlesergehäuse 5 ist bis auf den Karteneinführschlitz 12 der Frontwand 10 vollständig in sich geschlossen. Zum Schutz gegen Auseinanderbau und Aufbohren sind die Gehäusewände 5a-5e als mit einer Bohrschutz-Leiterbahnstruktur **21** versehene Leiterplatten (Platinen) ausgebildet, die miteinander steckverbunden und über innenseitige Lötflächen (Lötpads) **22** miteinander verlötet sind.

Wie in **Fig. 6** und in **Fign. 7a****,** **7b** gezeigt, weisen die obere und die untere Gehäusewand 5a, 5b jeweils zwei parallel zu ihren Längsrändern verlaufende Stecknuten **23** auf, in die die beiden Seitenwände 5c, 5d eingesteckt sind. Wie in Fig. 7a gezeigt, ist die Rückwand 5e einerseits in eine querverlaufende hintere Stecknut 23 der oberen Gehäusewand eingesteckt und mit einer eigenen querverlaufende Stecknut 23 hinten auf die untere Gehäusewand 5b aufgesteckt.

Wie in Fig. 6 am Beispiel der unteren Gehäusewand 5b gezeigt ist, weisen die obere und die untere Gehäusewand 5a, 5b jeweils eine querverlaufende, der Kontur des Bügelabschnitts 11 entsprechende vordere Stecknut **24** auf. Wie in Fig. 5b gezeigt, weisen auch die beiden Seitenwände 5c, 5d jeweils eine querverlaufende vordere Stecknut **25** auf. Im steckverbundenen Zustand dieser vier Gehäusewände 5a-5d bilden die Stecknuten 24, 25 eine innenseitig ringsum umlaufende Stecknut aus, in die der Bügelabschnitt 11 der Frontwand 10 allseitig eingesteckt ist. Die Frontplatte 10 ist mit den vier Seitenwänden 5a-5d nicht nur steckverbunden, sondern zum Schutz gegen Auseinanderbau auch miteinander verlötet. Dazu weisen sowohl die Seitenwände 5a-5d als auch die Polyimidfolienleiterplatte 15 der Frontplatte 10 entsprechende Lötflächen (nicht gezeigt) auf. Die untere Gehäusewand 5b weist innenseitig einen Stecker **26** auf, in den der Anschlussabschnitt 18 der Polyimidfolienleiterplatte 15 eingesteckt ist.

Wenn die miteinander verlöteten Gehäusewände 5a-5e, 10 voneinander abgehoben werden oder die Bohrschutz-Leiterbahnstrukturen 13, 21 durch Abschleifen oder Bohren zerstört werden, wird dadurch ein Stromkreis unterbrochen. Dies wird von einer Überwachungseinheit (nicht gezeigt) des Kartenlesers 1 oder von einer externen Überwachungseinheit erkannt, die dann keinen Lesevorgang mehr zulässt bzw. die Kontaktiereinheit außer Funktion setzt. Eine unbemerkte Manipulation am Kartenleser 1 ist somit nicht möglich, wodurch ein "sicherer Kartenleser (secure card reader)" bereitgestellt ist. Der Innenraum des Kartenlesers 1, in dem die Kontaktiereinheit und ggf. auch die Überwachungseinheit angeordnet sind, wird als "sicherer Bereich" bezeichnet.

## Patentansprüche

1. Kunststoffspritzteil (10) mit einer daran vorgesehenen Leiterbahnstruktur (13), insbesondere mit einer Bohrschutz-Leiterbahnstruktur, wobei die Leiterbahnstruktur (13) durch eine Kunststofffolienleiterplatte gebildet ist,
**dadurch gekennzeichnet,**
**dass** die Kunststofffolienleiterplatte durch eine Polyimidfolienleiterplatte (15) gebildet ist, die eine Polyimid-Trägerfolie (15a), eine Deckfolie (15c) und dazwischen eine Leiterbahnstrukturfolie (15b) aus Kupfer aufweist, welche miteinander jeweils über eine Klebstoffschicht (15d) verklebt sind, und dass zwischen der Polyimidfolienleiterplatte (15) und dem Kunststoffspritzteil (10) eine PET-Kunststofffolie (16) angeordnet ist, die auf die Polyimid-Trägerfolie (15a) der Polyimidfolienleiterplatte (15) aufgeklebt oder auflaminiert und mit dem Kunststoffspritzteil (10) stoffschlüssig hinterspritzt ist.

2. Kunststoffspritzteil nach Anspruch 1, **dadurch gekennzeichnet, dass** die Oberfläche des Kunststoffspritzteils (10), an der die Polyimidfolienleiterplatte (15) angebracht ist, eben und/oder gekrümmt und/oder gestuft ausgebildet ist.

3. Kunststoffspritzteil nach einem der vorhergehenden Ansprüche, **dadurch gekennzeichnet, dass** das Kunststoffspritzteil eine Gehäusewand (10) eines Kartenlesers (1) ist.

4. Kartenleser (1) zum Datenaustausch mit einer Datenkarte (2), insbesondere mit einer Chipkarte, mit einem Kartenlesergehäuse (5), bei dem mindestens eine Gehäusewand (10) durch ein Kunststoffspritzteil nach einem der vorhergehenden Ansprüche gebildet ist.

5. Kunststoffspritzteil nach Anspruch 4, **dadurch gekennzeichnet, dass** die Polyimidfolienleiterplatte (15) auch auf ihrer anderen Seite zumindest randseitig von dem Kunststoffteil (10) hinterspritzt ist.

6. Kartenleser nach Anspruch 4 oder 5, **dadurch gekennzeichnet, dass** die mindestens eine Gehäusewand eine mit einem Karteneinführschlitz (12) zum Einführen der Datenkarte (2) in den Kartenleser (1) versehene Frontwand (10) des Kartenlesergehäuses (5) ist.

7. Kartenleser nach Anspruch 6, **dadurch gekennzeichnet, dass** das Kartenlesergehäuse (5) vier ineinander gesteckte Seitenwände (5a-5d) umfasst, die als mit einer Bohrschutz-Leiterbahnstruktur (21) versehene Leiterplatten ausgebildet sind, welche miteinander elektrisch kontaktverbunden, insbesondere miteinander verlötet sind, und dass die vier ineinander gesteckten Seitenwände (5a-5d) eine innenseitig ringsum umlaufende Nut (24, 25) aufweisen, in welche die Frontwand (10) allseitig eingesteckt ist.

8. Kartenleser nach Anspruch 7, **dadurch gekennzeichnet, dass** die vier ineinander gesteckten Seitenwände (5a-5d) und die Polyimidfolienleiterplatte (15) der mit den Seitenwänden (5a-5d) steckverbundenen Frontwand (10) miteinander elektrisch kontaktverbunden, insbesondere miteinander verlötet sind.

9. Kartenleser nach Anspruch 7 oder 8, **dadurch gekennzeichnet, dass** das Kartenlesergehäuse (5) eine mit den vier Seitenwänden (5a-5d) steckverbundene Rückwand (5e) umfasst, die als eine mit einer Bohrschutz-Leiterbahnstruktur (21) versehene Leiterplatte ausgebildet ist, welche mit den Seitenwänden (5a-5d) elektrisch kontaktverbunden, insbesondere miteinander verlötet ist.

10. Folienverbund (14) aus einer Polyimidfolienleiterplatte (15), die eine Polyimid-Trägerfolie (15a), eine Deckfolie (15c) und dazwischen eine Leiterbahnstrukturfolie (15b) aus Kupfer aufweist, welche miteinander jeweils über eine Klebstoffschicht (15d) verklebt sind, und mindestens einer auf die Polyimid-Trägerfolie (15a) aufgeklebten oder auflaminierten PET-Kunststofffolie (16), die beim Spritzgießen eines Kunststoffteils (10) mit diesem stoffschlüssig verbunden ist.

11. Verfahren zum Ausbilden einer Leiterbahnstruktur (13), insbesondere einer Bohrschutz-Leiterbahnstruktur, an einem Kunststoffspritzteil (10), mit folgenden Verfahrensschritten:
- Befestigen einer PET-Kunststofffolie (16) auf einer flexiblen Polyimidfolienleiterplatte (15), die eine Polyimid-Trägerfolie (15a), eine Deckfolie (15c) und dazwischen eine Leiterbahnstrukturfolie (15b) aus Kupfer aufweist, welche miteinander jeweils über eine Klebstoffschicht (15d) verklebt sind, durch Aufkleben oder Auflaminieren der PET-Kunststofffolie (16) auf die Polyimid-Trägerfolie (15a) der Polyimidfolienleiterplatte (15); und
- Ausbilden eines Kunststoffspritzteils (10) durch Hinterspritzen der mit der PET-Kunststofffolie (16) abgedeckten Seite der flexiblen Polyimidfolienleiterplatte (15) im In-Mold-Spritzgießverfahren.

## Claims

1. Plastics injection-moulded component (10) having a strip conductor structure (13) which is provided thereon, in particular having a drill protection strip conductor structure, the strip conductor structure (13) being formed by a plastics film printed circuit board,
**characterised in that**
the plastics film printed circuit board is formed by a polyimide film printed circuit board (15) which has a polyimide carrier film (15a), a covering film (15c) and therebetween a strip conductor structure film (15b) of copper, which are adhesively bonded to each other by means of an adhesive layer (15d), respectively, and **in that** between the polyimide film printed circuit board (15) and the plastics injection-moulded component (10) there is arranged a PET plastics film (16) which is adhesively bonded or laminated to the polyimide carrier film (15a) of the polyimide film printed circuit board (15) and is back-injection-moulded in a materially integral manner with the plastics injection-moulded component (10).

2. Plastics injection-moulded component according to claim 1, **characterised in that** the surface of the plastics injection-moulded component (10), to which surface the polyimide film printed circuit board (15) is fitted, is constructed in a planar and/or curved and/or stepped manner.

3. Plastics injection-moulded component according to either of the preceding claims, **characterised in that** the plastics injection-moulded component is a housing wall (10) of a card reader (1).

4. Card reader (1) for data exchange with a data card (2), in particular with a chip card, having a card reader housing (5) in which at least one housing wall (10) is formed by means of a plastics injection-moulded component according to any one of the preceding claims.

5. Plastics injection-moulded component according to claim 4, **characterised in that** the polyimide film printed circuit board (15) is also back-injection-moulded at the other side thereof by the plastics injection-moulded component (10) at least at the peripheral side.

6. Card reader according to claim 4 or claim 5, **characterised in that** the at least one housing wall is a front wall (10) of the card reader housing (5), which wall is provided with a card introduction slot (12) for introducing the data card (2) into the card reader (1).

7. Card reader according to claim 6, **characterised in that** the card reader housing (5) comprises four side walls (5a-5d) which are inserted one inside the other and which are constructed as printed circuit boards which are provided with a drill protection strip conductor structure (21) and which are connected to each other in an electrically contacting manner, in particular soldered to each other, and **in that** the four side walls (5a-5d) which are inserted one inside the other have a groove (24, 25) which extends completely around at the inner side and in which the front wall (10) is inserted at all sides.

8. Card reader according to claim 7, **characterised in that** the four side walls (5a-5d) which are inserted one inside the other and the polyimide film printed circuit board (15) of the front wall (10) which is connected in a plug-like manner to the side walls (5a-5d) are connected to each other in an electrically contacting manner, in particular soldered to each other.

9. Card reader according to claim 7 or claim 8, **characterised in that** the card reader housing (5) comprises a rear wall (5e) which is connected in a plug-like manner to the four side walls (5a-5d) and which is constructed as a printed circuit board which is provided with a drill protection strip conductor structure (21) and which is connected to the side walls (5a-5d) in an electrically contacting manner, in particular soldered to each other.

10. Film composition (14) comprising a polyimide film printed circuit board (15) which has a polyimide carrier film (15a), a covering film (15c) and therebetween a strip conductor structure film (15b) of copper which are adhesively bonded to each other by means of a layer of adhesive (15d), respectively, and at least one PET plastics film (16) which is adhesively bonded or laminated to the polyimide carrier film (15a) and which is connected thereto in a materially integral manner during the injection-moulding operation of a plastics component (10).

11. Method for constructing a strip conductor structure (13), in particular a drill protection strip conductor structure, on a plastics injection-moulded component (10) having the following method steps:
- securing a PET plastics film (16) to a flexible polyimide film printed circuit board (15) which has a polyimide carrier film (15a), a covering film (15c) and therebetween a strip conductor structure film (15b) of copper, which are adhesively bonded to each other by means of a layer of adhesive (15d), respectively, by means of adhesively bonding or laminating the PET plastics film (16) to the polyimide carrier film (15a) of the polyimide film printed circuit board (15); and
- constructing a plastics injection-moulded component (10) by means of back-injection-moulding the side of the flexible polyimide film printed circuit board (15), which side is covered with the PET plastics film (16), with the in-mould injection-moulding method.

## Revendications

1. Pièce injectée en matière plastique (10) avec une structure à pistes conductrices (13) prévue sur elle, en particulier avec une structure à pistes conductrices de protection contre le perçage, la structure à pistes conductrices (13) étant formée par une carte de circuit imprimé en feuille de matière plastique (15),
**caractérisée en ce**
**que** la carte de circuit imprimé en feuille de matière plastique est formée par une carte de circuit imprimé en feuille de polyimide (15) qui présente une feuille de support en polyimide (15a), une feuille de recouvrement (15c) et entre les deux une feuille de structure à pistes conductrices (15b) en cuivre, lesquelles sont chaque fois collées ensemble par une couche d'adhésif (15d), et qu'entre la carte de circuit imprimé en feuille de polyimide (15) et la pièce injectée en matière plastique (10) est disposé une feuille de matière plastique PET (16) qui est collée ou laminée sur la feuille de support en polyimide (15a) de la carte de circuit imprimé en feuille de polyimide (15) et surmoulée par injection pour créer une liaison de matière avec la pièce injectée en matière plastique (10).

2. Pièce injectée en matière plastique selon la revendication 1, **caractérisée en ce que** la surface de la pièce injectée en matière plastique (10) sur laquelle la carte de circuit imprimé en feuille de polyimide (15) est appliquée, est plane et/ou courbe et/ou étagée.

3. Pièce injectée en matière plastique selon l'une des revendications précédentes, **caractérisée en ce que** la pièce injectée en matière plastique est une paroi de boîtier (10) d'un lecteur de cartes (1).

4. Lecteur de cartes (1) pour l'échange de données avec une cartes de données (2), en particulier avec une carte à puce, comportant un boîtier de lecteur de cartes (5), dont au moins une paroi de boîtier (10) est formée par une pièce injectée en matière plastique selon l'une des revendications précédentes.

5. Pièce injectée en matière plastique selon la revendication 5, **caractérisée en ce que** la carte de circuit imprimé en feuille de polyimide (15) est aussi surmoulée par la pièce en matière plastique (10) sur son autre côté, au moins dans la région des bords.

6. Lecteur de cartes selon la revendication 4 ou 5, **caractérisé en ce que** ladite au moins une paroi de boîtier est une paroi frontale (10) du boîtier de lecteur de cartes (5) munie d'une fente d'introduction de carte (12) permettant d'introduire la carte de données (2) dans le lecteur de cartes (1).

7. Lecteur de cartes selon la revendication 6, **caractérisée en ce que** le boîtier de lecteur de cartes (5) comprend quatre parois latérales emboîtées (5a-5d) qui sont formées comme des cartes de circuit imprimé munies d'une structure à pistes conductrices de protection contre le perçage (21), lesquelles sont reliées entre elles électriquement par contact, en particulier brasées entre elles, et que les quatre parois latérales emboîtées (5a-5d) présentent une rainure périphérique intérieure (24, 25) dans laquelle la paroi frontale (10) est enfichée de tous côtés.

8. Lecteur de cartes selon la revendication 7, **caractérisé en ce que** les quatre parois latérales emboîtées (5a-5d) et la carte de circuit imprimé en feuille de polyimide (15) de la paroi frontale (10) reliée aux parois latérales (5a-5d) par enfichage sont reliées entre elles électriquement par contact, en particulier brasées entre elles.

9. Lecteur de cartes selon la revendication 7 ou 8, **caractérisé en ce que** le boîtier de lecteur de cartes (5) comprend une paroi arrière (5e) reliée aux quatre parois latérales (5a-5d) par enfichage, qui est formée comme une carte de circuit imprimé munie d'une structure à pistes conductrices de protection contre le perçage (21), laquelle est reliée aux parois latérales (5a-5d) électriquement par contact, en particulier brasée avec elles.

10. Composite de feuilles (14) composé d'une carte de circuit imprimé en feuille de polyimide (15) qui présente une feuille de support en polyimide (15a), une feuille de recouvrement (15c) et entre les deux une feuille de structure à pistes conductrices (15b) en cuivre, lesquelles sont chaque fois collées ensemble par une couche d'adhésif (15d), et au moins une feuille de matière plastique PET (16) collée ou laminée sur la feuille de support en polyimide (15a), qui, lors du moulage par injection d'une pièce en matière plastique (10), est reliée à celle-ci par liaison de matière.

11. Procédé pour former une structure à pistes conductrices (13), en particulier une structure à pistes conductrices de protection contre le perçage, sur une pièce injectée en matière plastique (10), présentant les étapes suivantes :
- fixation d'une feuille de matière plastique PET (16) sur une carte de circuit imprimé flexible en feuille de polyimide (15) qui présente une feuille de support en polyimide (15a), une feuille de recouvrement (15c) et entre les deux une feuille de structure à pistes conductrices (15b) en cuivre, lesquelles sont chaque fois collées ensemble par une couche d'adhésif (15d), par collage ou laminage de la feuille de matière plastique PET (16) sur la feuille de support en polyimide (15a) de la carte de circuit imprimé en feuille de polyimide (15) ; et
- formation d'une pièce injectée en matière plastique (10) par surmoulage du côté de la carte de circuit imprimé flexible en feuille de polyimide (15) recouvert de la feuille de matière plastique PET (16) par le procédé de moulage par injection dans le moule.
